# EUROPEAN PATENT APPLICATION

(11) **EP 1 056 196 A2**
(43) Date of publication of application: **29.11.2000**
(21) Application number: 00111187.1
(22) Date of filing: 24.05.2000
(51) Int. Cl.: H03F 3/45

(54) **Amplifying circuit**

(30) Priority: 24.05.1999 JP 14376999
(71) Applicant: MATSUSHITA ELECTRIC INDUSTRIAL CO., LTD., Kadoma-shi, Osaka-fu, 571 (JP)
(72) Inventor: Uno, Hitoshi, Yokohama-shi, Kanagawa (JP)
(74) Representative: Grünecker, Kinkeldey, Stockmair & Schwanhäusser Anwaltssozietät

(57) **Abstract**

There are described an amplifying circuit unit and an amplifying circuit which can momentarily compensate for a d.c. potential offset of a difference output signal stemming from a d.c. potential offset of a difference input signal and achieve a good characteristic. The amplifying circuit unit includes a differential amplifying circuit which receives and amplifies positive-phase and negative-phase signals; a first peak detection circuit for detecting a peak value of the positive-phase signal input to the differential amplifying circuit; a second peak detection circuit for detecting a peak value of the negative-phase signal input to the differential amplifying circuit; and an offset compensation circuit for compensating for a d.c. potential offset arising in a differential signal output from the differential amplifying circuit, on the basis of the peak values detected by the peak detection circuits.

## Description

### BACKGROUND OF THE INVENTION

### 1.Field of the Invention

The present invention relates to an amplifying circuit unit for momentarily reducing a d.c. potential offset of a difference output signal stemming from a d.c. potential offset of a difference input signal, as well as to an amplifying circuit formed by connection of a plurality of amplifying circuit units arranged in stages. The amplifying circuit unit and the amplifying circuit are applied especially to an optical receiving circuit.

### 2.Description of the Related Art

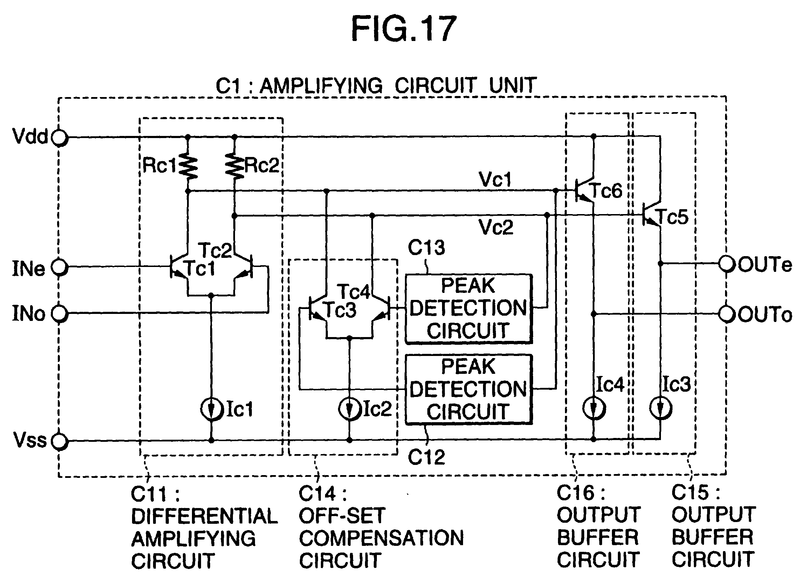

FIG. 17 is a schematic diagram showing a commonly-known amplifying circuit. Reference symbol Vdd designates a high-potential power terminal; Vss designates a low-potential power terminal; INe designates a positive-phase signal input terminal; INo designates a negative-phase signal input terminal; OUTe designates a positive-phase signal output terminal; and OUTo designates a negative-phase signal output terminal. An amplifying circuit C1 comprises a differential amplifier circuit C11, a first peak detection circuit C12, a second peak detection circuit C13, an offset compensation circuit C14, an output buffer circuit C15, and an output buffer circuit C16. In the differential amplifier circuit C11, the emitter of a first transistor Tc1 and the emitter of a second transistor Tc2, the transistors Tc1 and Tc2 having identical characteristics, are connected to a common first constant-current power source Ic1. Further, the collector of the first transistor Tc1 is connected to a first load resistor Rc1, and the collector of the second transistor Tc2 is connected to a second load resistor Rc2. The base of the first transistor Tc1 is connected to the positive-phase signal input terminal INe, and the base of the second transistor Tc2 is connected to the negative-phase signal input terminal INo. An amplified positive-phase signal is output from a node between the first transistor Tc1 and the first load resistor Rc1, and an amplified negative-phase signal is output from a node between the second transistor Tc2 and the second load resistor Rc2. The first peak detection circuit C12 detects a peak value of the positive-phase signal output from the differential amplifier circuit C11. The second peak detection circuit C13 detects a peak value of the negative-phase signal output from the same. The emitter of a third transistor Tc3 and the emitter of a fourth transistor Tc4, the transistors Tc3 and Tc4 having identical characteristics, are connected to a common second constant-current power source Ic2. The base of the third transistor Tc3 is connected to an output terminal of the first peak detection circuit C12, and the base of the fourth transistor Tc4 is connected to an output terminal of the second peak detection circuit C13. The collector of the third transistor Tc3 is connected to the node between the first transistor Tc1 and the first load resistor Rc1 of the differential amplifier circuit C11. The collector of the fourth transistor Tc4 is connected to the node between the second transistor Tc2 and the second load resistor Rc2. The output buffer circuit C15 comprises a fifth transistor Tc5 and a constant-current power source Ic3 and extracts the positive-phase signal output from the differential amplifier circuit C11. The output buffer circuit C16 comprises a sixth transistor Tc6 and a constant-current power source Ic4 and extracts the negative-phase signal output from the differential amplifier circuit C11.

The base of the transistor Tc3 constituting the offset compensation circuit C14 receives a peak value of the positive-phase signal Vc1 output from the differential amplifier circuit C11. Further, the base of the transistor Tc4 receives a peak value of the negative-phase signal Vc2 output from the differential amplifier circuit C11. The collector current flowing through the transistor Tc3 changes according to the peak value of the positive-phase output signal Vc1, and the collector current flowing through the transistor Tc4 changes according to the peak value of the negative-phase output signal Vc2.

Assume that the d.c. potential of the collector of the transistor Tc1 in the differential amplifier circuit C11 is higher than the d.c. potential of the collector of the transistor Tc2. At this time, the potential of the signal output from the peak detection circuit C12 is higher than the potential of the signal output from the peak detection circuit C13. Accordingly, the collector current of the transistor Tc3 of the offset compensation circuit C14 becomes greater than the collector current of the transistor Tc4. As a result, there is compensated an offset between the d.c. potential of the collector of the transistor Tc2 of the differential amplifier circuit C11 and the d.c. potential of the collector of the transistor Tc1.

An optical communication scheme using a burst-like data signal has recently been under study, and demand exists for an optical receiving circuit which responds at high speed to initiation of data entry.

In a case where the foregoing commonly-known amplifying circuit unit is used as an optical receiving circuit, sufficient response of the optical receiving circuit for initiating data entry has not been achieved, for reasons of feedback offset compensation which is effected in the optical receiving circuit.

### SUMMARY OF THE INVENTION

The present invention is aimed at providing an amplifying circuit unit and an amplifying circuit which can momentarily compensate for a d.c. potential offset of a difference output signal stemming from a d.c. potential offset of a difference input signal and achieve a good characteristic.

In order to compensate for an offset of an output signal and to achieve high-speed response to initiation of data entry, the present invention provides an amplifying circuit unit comprising:
a differential amplifying circuit which receives and amplifies positive-phase and negative-phase signals;
peak detection circuits, one for detecting a peak value of the positive-phase signal input to the differential amplifying circuit and the other for detecting a peak value of the negative-phase signal input to the differential amplifying circuit; and
an offset compensation circuit for compensating for a d.c. potential offset arising in a differential signal output from the differential amplifying circuit, on the basis of the peak values detected by the peak detection circuits. Such a circuit configuration enables compensation for a d.c. potential offset of a differential output signal stemming from a d.c. potential offset of a differential input signal and realization of high-speed response to initiation of data entry.

More specifically, the present invention provides an amplifying circuit unit comprising:
a differential amplifying circuit which receives and amplifies positive-phase and negative-phase signals;
peak detection circuits, one for detecting a peak value of the positive-phase signal input to the differential amplifying circuit and the other for detecting a peak value of the negative-phase signal input to the differential amplifying circuit; and
an offset compensation circuit for compensating for a d.c. potential offset arising in a differential signal output from the differential amplifying circuit, on the basis of the peak values detected by the peak detection circuits. Such a circuit configuration enables compensation for a d.c. potential offset of a differential output signal stemming from a d.c. potential offset of a differential input signal and realization of high-speed response to initiation of data entry. Further, according to the present invention, the amplifying circuit unit may be configured so as to comprise:
a differential amplifying circuit, including
   first and second transistors having identical
      characteristics;
   a first common constant-current power source connected to the emitter or source of the first transistor and the emitter or source of the second transistor;
   a first load connected to the collector or drain of the first transistor directly or by way of cascade-connected transistors;
   a second load connected to the collector or drain of the first transistor directly or by way of cascade-connected transistors, wherein the differential amplifying circuit receives a positive-phase signal by way of the base or gate of the first transistor and a negative-phase signal by way of the base or gate of the second transistor and outputs an amplified positive-phase signal by way of the collector or drain of the first transistor and an amplified negative-phase signal by way of the collector or drain of the second transistor;
a first peak detection circuit for detecting a peak value of the positive-phase signal input to the differential amplifying circuit;
a second peak detection circuit for detecting a peak value of the negative-phase signal input to the differential amplifying circuit; and
an offset compensation circuit including,
   third and fourth transistors having identical characteristics;
   a second common constant-current power source connected to the emitter or source of the third transistor and the emitter or source of the fourth transistor;
   the base or gate of the third transistor being connected to an output terminal of the first peak detection circuit;
   the base or gate of the fourth transistor being connected to an output terminal of the second peak detection circuit;
   the collector or drain of the third transistor being connected to the collector or drain of the second transistor of the differential amplifying circuit; and
   the collector or drain of the fourth transistor being connected to the collector or drain of the first transistor of the differential amplifying circuit. As a result, the present invention yields an advantages of compensation for a d.c. potential offset of a differential output signal stemming from a d.c. potential offset of a differential input signal and realization of high-speed response to initiation of data entry.

Preferably, the amplifying circuit is formed from the amplifying circuit units cascaded into stages. An offset voltage of an output signal due to variations in integrated circuits of an amplifying circuit unit of one stage, which would arise during manufacture of the integrated circuits, is compensated for by an amplifying circuit unit of the next stage. The amplifying circuit of the present invention can yield an advantage of ability to materialize a wide input dynamic range by means of improving minimum receiving sensitivity. Further, the advantages yielded by the previously-described amplifying circuit units are also yielded.

According to the present invention, the amplifying circuit unit may be configured so as to comprise:
a differential amplifying circuit which receives and amplifies positive-phase and negative-phase signals;
peak detection circuits, one for detecting a peak value of the positive-phase signal input to the differential amplifying circuit and the other for detecting a peak value of the negative-phase signal input to the differential amplifying circuit;
an offset compensation circuit for compensating for a d.c. potential offset arising in a differential signal output from the differential amplifying circuit, on the basis of the peak values detected by the peak detection circuits; and
a reset signal terminal provided for the peak detection circuits, wherein the peak detection circuits have a reset terminal which, upon receipt of a reset signal, can make the potential of a positive-phase input signal substantially equal to that of a positive-phase output signal and the potential of a negative-phase input signal substantially equal to that of a negative-phase output signal. Further, according to the present invention, an amplifying circuit unit may be embodied so as to comprise:
a differential amplifying circuit, including
   first and second transistors having identical characteristics;
   a first common constant-current power source connected to the emitter or source of the first transistor and the emitter or source of the second transistor;
   a first load connected to the collector or drain of the first transistor directly or by way of cascade-connected transistors;
   a second load connected to the collector or drain of the first transistor directly or by way of cascade-connected transistors, wherein the differential amplifying circuit receives a positive-phase signal by way of the base or gate of the first transistor and a negative-phase signal by way of the base or gate of the second transistor and outputs an amplified positive-phase signal by way of the collector or drain of the first transistor and an amplified negative-phase signal by way of the collector or drain of the second transistor;
a first peak detection circuit for detecting a peak value of the positive-phase signal input to the differential amplifying circuit;
a second peak detection circuit for detecting a peak value of the negative-phase signal input to the differential amplifying circuit; and
an offset compensation circuit including,
   third and fourth transistors having identical characteristics;
   a second common constant-current power source connected to the emitter or source of the third transistor and the emitter or source of the fourth transistor;
   the base or gate of the third transistor being connected to an output terminal of the first peak detection circuit;
   the base or gate of the fourth transistor being connected to an output terminal of the second peak detection circuit;
   the collector or drain of the third transistor being connected to the collector or drain of the second transistor of the differential amplifying circuit; and
   the collector or drain of the fourth transistor being connected to the collector or drain of the first transistor of the differential amplifying circuit, wherein the first and second peak detection circuits have a reset terminal which, upon receipt of a reset signal, can make the potential of a signal input to the first peak detection circuit substantially equal to that of a signal output therefrom and the potential of a signal input to the second peak detection circuit substantially equal to that of a signal output therefrom. Accordingly, in addition to the advantage yielded by the previously-described amplifying circuit, the amplifying circuit unit yields an advantage of ability to respond at high speed to initiation of data entry even in a case where a low-level burst signal is input to the amplifying circuit immediately after a high-level burst signal.

The present invention also provides an amplifying circuit comprising:
a plurality of circuit units cascaded into a plurality of stages; and
delay circuits interposed between the amplifying circuit units, wherein a reset signal terminal of an amplifying circuit unit of the first stage is taken as a reset signal terminal for all the amplifying circuit units. In addition to the high-speed response of the amplifying circuit unit, the amplifying circuit unit yields an advantage of ability to ensure an input dynamic range.

Preferably, a comparator having a hysteresis characteristic is connected to an output terminal of the amplifying circuit unit. The amplifying circuit yields an advantage of preventing an output of the amplifying circuit unit from becoming indefinite in the event of occurrence of a period during which signals of the same sign are continuously input to the amplifying circuit unit or the amplifying circuit unit receives no signal, in addition to the advantage yielded by the previous amplifying circuit unit.

Preferably, a comparator having a hysteresis characteristic is connected to an output terminal of the amplifying circuit. In addition to the previously-described advantage yielded by the amplifying circuit, the amplifying circuit yields, an advantage of being able to prevent an output of the amplifying circuit from becoming indefinite, which would otherwise occur during a period in which signals of the same sign are continuously input to the amplifying circuit or the amplifying circuit receives not signal.

Preferred embodiments relating to the amplifying circuit unit as well as to the amplifying circuit using the amplifying circuit units will be described hereinbelow by reference to the accompanying drawings.

Although the following embodiments will be described by reference to an example in which bipolar transistors are used for the amplifying circuit unit and for the amplifying circuit, the amplifying circuit unit and the amplifying circuit according to the present invention can also be embodied through use of field-effect transistors and yield the same advantages as those yielded in the case where the bipolar transistors are employed.

### BRIEF DESCRIPTION OF THE DRAWINGS

FIG. 1 is a schematic diagram showing an example configuration of an amplifying circuit unit according to a first embodiment of the present invention;
FIGS. 2A and 2B are illustrations for describing the operation of the amplifying circuit unit according to the first embodiment, showing waveforms of signals input to and output from a differential amplifying circuit in a case where the amplifying circuit unit has no offset compensation circuit;
FIGS. 3A and 3B are illustrations for describing the operation of the amplifying circuit unit according to the first embodiment, showing waveforms of signals input to and output from a differential amplifying circuit in a case where the amplifying circuit unit has an offset compensation circuit;
FIG. 4 is a circuit diagram showing constituent blocks of the amplifying circuit unit according to the first embodiment;
FIG. 5 is a schematic diagram showing an amplifying circuit according to a second embodiment of the present invention;
FIG. 6 is a schematic diagram showing an example configuration of an optical receiving circuit using the amplifying circuit unit according to the first embodiment shown in FIG. 1;
FIG. 7 is an illustration showing waveforms of signals appearing in individual sections of the optical receiving circuit which uses the amplifying circuit unit according to the first embodiment shown in FIG. 6;
FIG. 8 is an illustration for describing a problem, which would arise in the optical receiving circuit using the amplifying circuit unit according to the first embodiment shown in FIG. 7 in the event of a momentary reduction arising in the level of an input signal;
FIG. 9 is a schematic diagram showing an amplifying circuit unit according to a third embodiment of the present invention;
FIG. 10 is a schematic diagram showing an example configuration of an optical receiving circuit using the amplifying circuit unit according to the third embodiment shown in FIG. 9;
FIG. 11 is an illustration showing waveforms of signals appearing in individual sections of the optical receiving circuit which uses the amplifying circuit unit according to the third embodiment shown in FIG. 10;
FIG. 12 is a schematic diagram showing an amplifying circuit according to a fourth embodiment of the present invention;
FIG. 13 is a graph showing the input/output characteristics of a comparator used with the amplifying circuit according to a fifth embodiment of the present invention;
FIG. 14 is an illustration for describing a problem, which would arise when signals of the same sign are input to the optical receiving circuit using the amplifying circuit unit according to the first embodiment shown in FIG. 1 or the optical receiving circuit using the amplifying circuit unit according to the third embodiment shown in FIG. 9;
FIG. 15 is an illustration for describing the operation of the optical receiving circuit shown in FIG. 10 when a comparator used in the optical receiving circuit is given the input/output characteristics shown in FIG. 13;
FIG. 16 is an illustration for describing the operation of the optical receiving circuit shown in FIG. 6 or 10 when a comparator used in the optical receiving circuit is given the input/output characteristics shown in FIG. 13 and in a case where signals of the same sign are input to the optical receiving circuit; and
FIG. 17 is a schematic diagram showing a commonly-known amplifying circuit unit.

### DESCRIPTION OF THE PREFERRED EMBODIMENTS

### (First Embodiment)

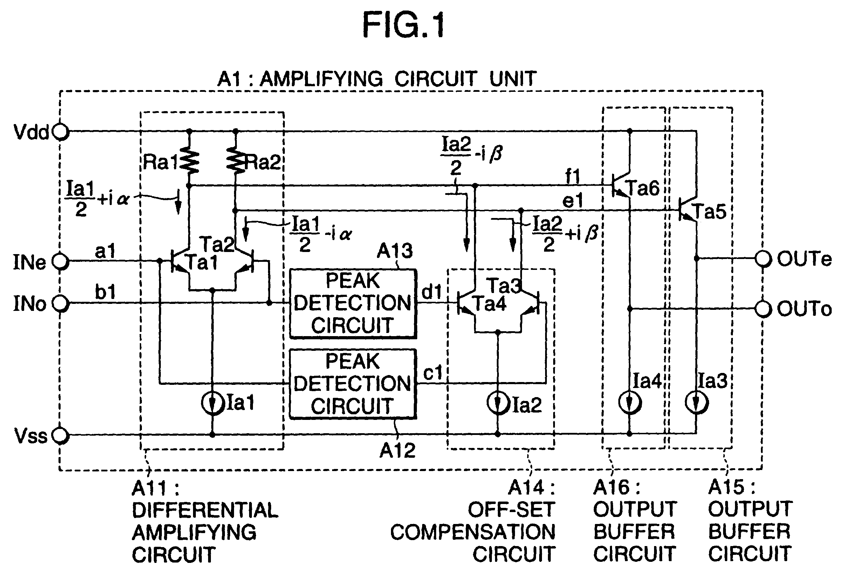

FIG. 1 is a circuit diagram showing an example configuration of a basic amplifying circuit (an amplifying circuit unit) A1 according to a first embodiment of the present invention. The amplifying circuit unit A1 essentially comprises a differential amplifying circuit A11, a first peak detection circuit A12, a second peak detection circuit A13, an offset compensation circuit A14, an output buffer circuit A15, and an output buffer circuit A16. Reference symbol Vdd designates a high-potential power terminal; Vss designates a low-potential power terminal; INe designates a positive-phase signal input terminal; INo designates a negative-phase signal input terminal; OUTe designates a positive-phase signal output terminal; and OUTo designates a negative-phase signal output terminal.

The differential amplifier circuit A11 has first and second transistors Ta1 and Ta2, the transistors having identical characteristics. The emitter of the first transistor Ta1 and the emitter of the second transistor Ta2 are connected to a low-potential power terminal Vss by way of a common first constant-current power source Ia1. The collector of the first transistor Ta1 is connected to the high-potential power terminal Vdd by way of a first load resistor Ra1, and the collector of the second transistor Ta2 is connected to the high-potential power terminal Vdd by way of a second load resistor Ra2. The base of the first transistor Ta1 is connected to the positive-phase signal input terminal INe, and the base of the second transistor Ta2 is connected to the negative-phase signal input terminal INo. The differential amplifier circuit A11 outputs an amplified positive-phase signal by way of a node between the first transistor Ta1 and the first load resistor Ra1. The differential amplifier circuit A11 outputs an amplified negative-phase signal by way of a node between the second transistor Ta2 and the second load resistor Ra2. The resistance of the first load resistor Ra1 is equal to that of the second load resistor Ra2.

The input terminal of the first peak detection circuit A12 is connected to the positive-phase signal input terminal INe, and the input terminal of the second peak detection circuit A13 is connected to the negative-phase signal input terminal INo.

The offset compensation circuit A14 has a third transistor Ta3 and a fourth transistor Ta4, the transistors having identical characteristics. The emitter of the third transistor Ta3 and that of the fourth transistor Ta4 are connected to the low-potential power terminal Vss by way of a common second constant-current power supply Ia2. The base of the third transistor Ta3 is connected to the output terminal of the first peak detection circuit A12, and the base of the fourth transistor Ta4 is connected to the output terminal of the second peak detection circuit A13. The collector of the third transistor Ta3 is connected to a node between the second transistor Ta2 and the second load resistor Ra2, and the collector of the fourth transistor Ta4 is connected to a node between the first transistor Ta1 and the first load resistor Ra1.

In the output buffer circuit A15, the base of a fifth transistor Ta5 is connected to the node between the second transistor Ta2 and the second load resistor Ra2 of the differential amplifier circuit A11. The collector of the transistor Ta5 is connected to the high-potential power terminal Vdd, and the emitter of the same is connected to the positive-phase signal output terminal OUTe, and to the low-potential power terminal Vss by way of a third constant-current power source Ia3.

In the output buffer circuit A16, the base of a sixth transistor Ta6 is connected to the node between the first transistor Ta1 and the first load resistor Ra1 of the differential amplifier circuit A11. The collector of the transistor Ta6 is connected to the high-potential power terminal Vdd, and the emitter of the same is connected to the negative-phase signal output terminal OUTo, and to the low-potential power terminal Vss by way of a fourth constant-current power source Ia4.

In the differential amplifier circuit A11 shown in FIG. 1, the electric current flowing through the load resistor Ra1 essentially corresponds to the sum of half the electric current supplied from the constant-current power source Ia1 and an electric current iα proportional to a difference between the difference input signal a1 input to the positive-phase signal input terminal INe and a difference input signal b1 input to the negative-phase signal input terminal INo. Further, the electric current flowing through the load resistor Ra2 essentially corresponds to the sum of half the electric current supplied from the constant-current power source Ia1 and an electric current iα proportional to a difference between the difference input signal a1 input to the positive-phase signal input terminal INe and the difference input signal b1 input to the negative-phase signal input terminal INo.

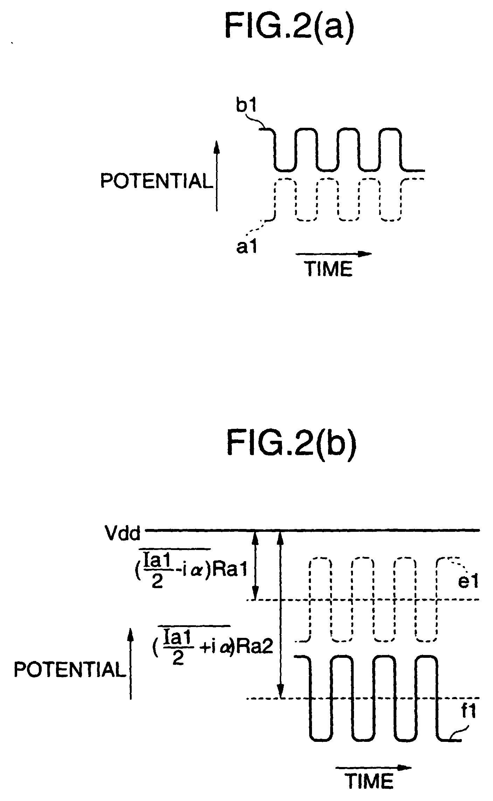

In a case where the offset compensation circuit A14 is not connected to the amplifying circuit unit A1, if the difference input signal a1 having a d.c. potential offset, such as that shown in FIG. 2A, enters the positive-phase signal input terminal INe and if the difference input signal b1 having a d.c. potential offset, such as that shown in FIG. 2A, enters the negative-phase signal input terminal INo, a d.c. potential offset, such as that shown in FIG. 2B, arises in each of voltage signals e1 and f1 output from the differential amplifier circuit A11.

In the offset compensation circuit A14 shown in FIG. 1, the electric current flowing through the load resistor Ra2 essentially corresponds to the sum of half the electric current supplied from the constant-current power source Ia2 and an electric current iβ proportional to a difference between a peak value c1 of the difference input signal a1 detected by the peak detection circuit A12 and a peak value d1 of the difference input signal b1 detected by the peak detection circuit A13. Further, the electric current flowing through the load resistor Ra1 corresponds to an electric current defined by subtraction of half the electric current supplied from the constant-current power source Ia2 from an electric current iβ proportional to a difference between the peak value c1 of the difference input signal a1 detected by the peak detection circuit A12 and the peak value d1 of the difference input signal b1 detected by the peak detection circuit A13. As a result, the d.c. potential offsets of the respective voltage signals e1 and f1 output from the differential amplifier circuit A11 can be compensated for.

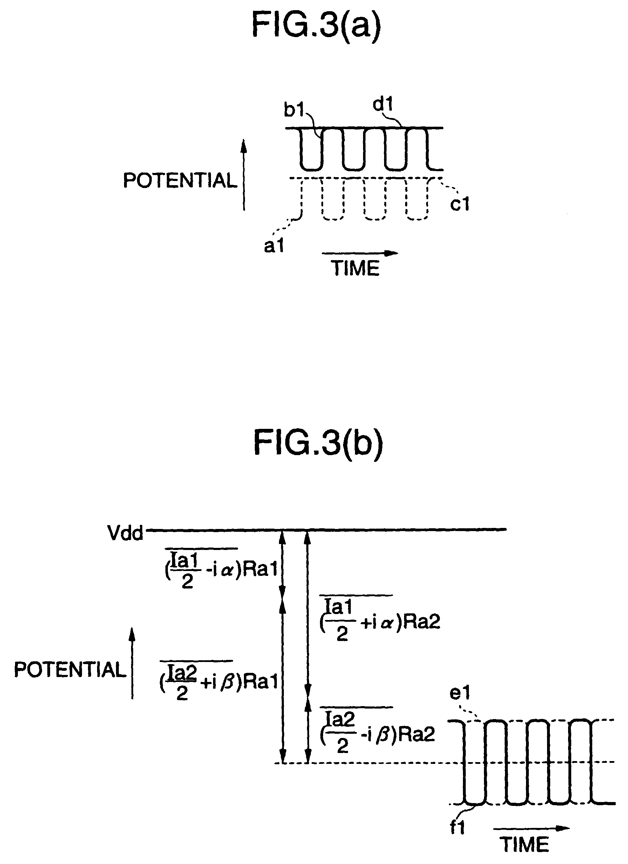

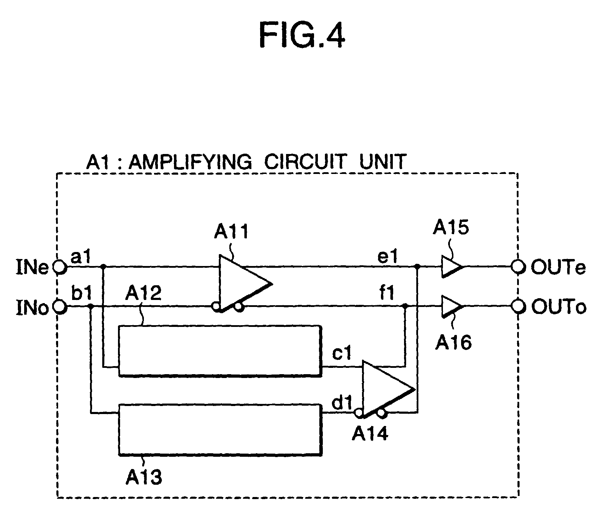

FIGS. 3A and 3B depict waveforms of voltage signals appearing in the individual sections of the amplifying circuit unit A1 having the offset compensation circuit A14 connected thereto. FIG. 3A shows the difference input signals a1 and b1, each having a d.c. potential offset; the peak value c1 of the difference input signal a1, and the peak value d1 of the difference input signal b1. FIG. 3B shows the voltage signals e1 and f1, the d.c. potential offsets of which have been compensated for by the offset compensation circuit A14. In this way, the amplifying circuit according to the first embodiment can compensate for a d.c. potential offset of a respective differential output signal stemming from a d.c. potential offset of a difference input signal and has a circuit configuration of feed-forward type. Therefore, the amplifying circuit unit A1 yields an advantage of ability to respond at high speed to initiation of data entry. FIG. 4 is a block diagram showing the configuration of the amplifying circuit unit A1 of the first embodiment shown in FIG. 1.

### (Second Embodiment)

The amplifying circuit unit A1, which has been described in connection with the first embodiment, can compensate for a d.c. potential offset of a respective differential output signal stemming from a d.c. potential offset of a difference input signal. However, since the amplifying circuit unit A1 has a circuit configuration of feed-forward type, the amplifying circuit unit A1 cannot compensate for a d.c. potential offset of a differential output signal stemming from variations in integrated circuits, which would arise during manufacture of the integrated circuits.

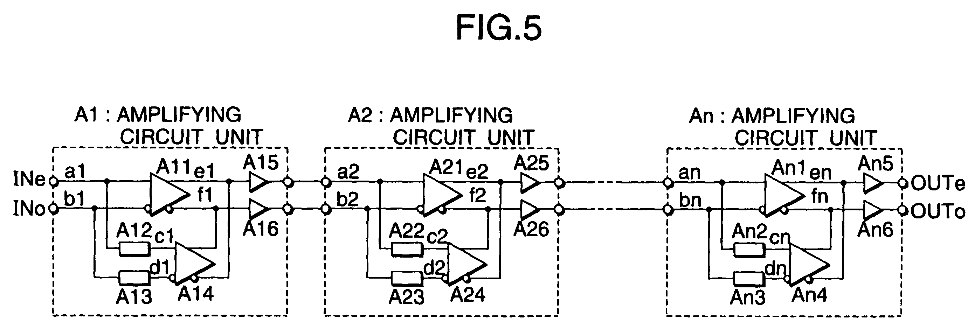

FIG. 5 is a circuit diagram showing an amplifying circuit according to a second embodiment of the present invention for solving the previously-described problem of the background art. The amplifying circuit shown in FIG. 5 is made by concatenation of "n" stages of amplifying circuit units A1 to An, each amplifying circuit unit being identical with the amplifying circuit unit A1 according to the first embodiment.

In addition to the same advantage as that yielded by the amplifying circuit unit A1 according to the first embodiment, the amplifying circuit according to the second embodiment yields an advantage of ability to compensate for a d.c. potential offset of a differential output signal stemming from variations in integrated circuits of an amplifying circuit of a previous stage, which variations would arise during manufacture of the integrated circuits, by means of the amplifying circuit unit of the next stage daisy-chained to the previous amplifying circuit unit. The amplifying circuit according to the second embodiment also yields an advantage of ability to improve the minimum receiving sensitivity, to thereby achieve a wide input dynamic range. Further, concatenation of the amplifying circuit units enables a reduction in the gain required per stage and significant relaxation of the precision required for the basis amplifying circuit unit in the respective stage.

### (Third Embodiment)

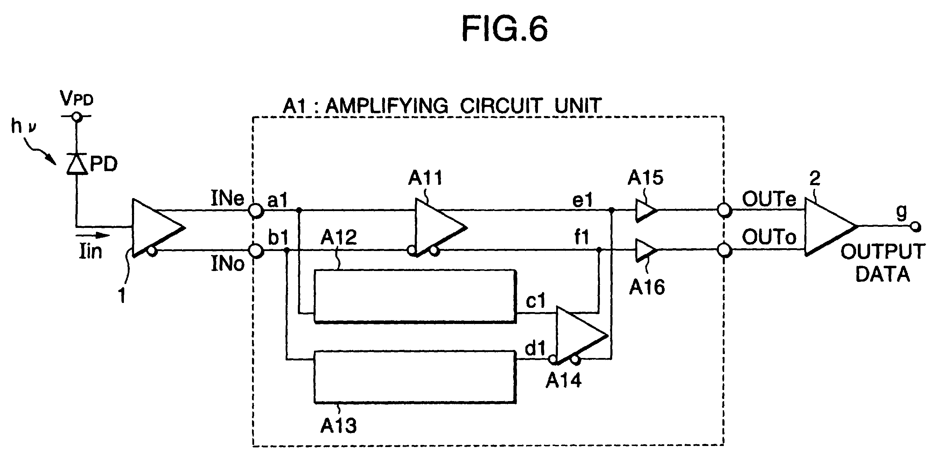

FIG. 6 is a circuit diagram showing an example configuration of an optical receiving circuit using the amplifying circuit unit A1 according to the first embodiment shown in FIG. 1. A light-receiving element PD (photo-diode) converts an optical signal hν into an current signal Iin and outputs the current signal Iin to a preamplifying circuit 1 of differential output type.

The preamplifying circuit 1 converts the current signal Iin into a positive-phase voltage signal and a negative-phase voltage signal. Respective output terminals of the preamplifying circuit 1 are connected to the positive-phase signal input terminal INe and the negative-phase signal input terminal INo. The positive-phase signal output terminal OUTe and the negative-phase signal output terminal OUTo of the amplifying circuit unit A1 are connected to respective input terminals of a comparator 2. The comparator 2 compares voltages of the voltage signals―which have been amplified by the amplifying circuit A1 and have equal d.c. potentials and opposite phases―and outputs a pulse signal data string whose logical values are identifiable.

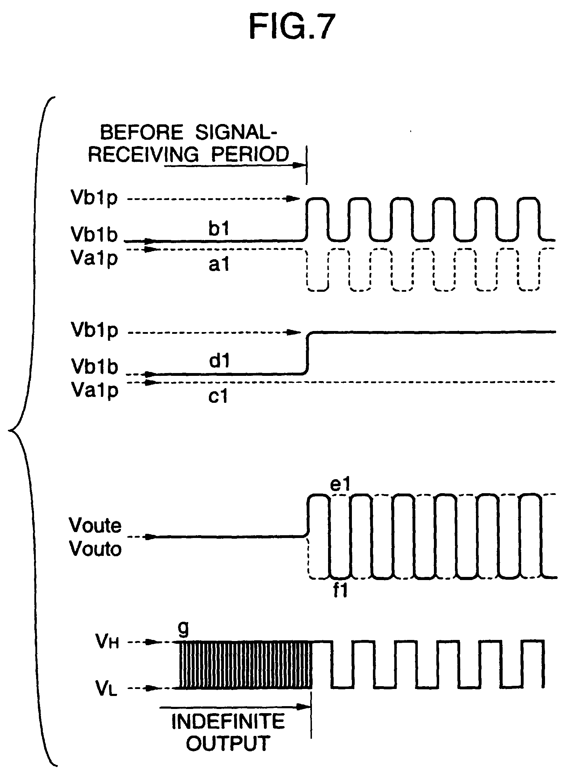

FIG. 7 shows waveforms of the signals appearing in the individual sections of the amplifying circuit unit A1 and a waveform "g" of the signal output from the comparator 2. The differential amplifier circuit A11 receives the difference input signals a1 and b1 and outputs the voltage signals e1 and f1. The peak detection circuit A12 detects and holds a peak value Va1p of the difference input signal a1, and the peak detection circuit A13 detects and holds a peak value Vb1p of the difference input signal b1. The peak value Va1p is output from the peak detection circuit A12 to the offset compensation circuit A14 as the peak value c1, and the peak value Vb1p is output from the peak detection circuit A13 to the offset compensation circuit A14 as the peak value d1.

On the basis of a difference between the peak value c1 output from the peak detection circuit A12 and the peak value d1 output from the peak detection circuit A13, the offset compensation circuit A14 compensates for a d.c. potential offset of the voltage signal e1 stemming from the d.c. potential offset of the differential input signal a1, as well as for a d.c. potential offset of the voltage signal f1 stemming from the d.c. potential offset of the differential input signal b1, thereby rendering the d.c. potential of the voltage signal e1 substantially equal to that of the voltage signal f1. After having been buffered by the output buffer circuit A15, the voltage signal e1 enters the comparator 2. After having been buffered by the output buffer circuit A16, the voltage signal f1 enters the comparator 2. The comparator 2 compares the voltages of respective voltage signals e1 and f1, thereby outputting a pulse signal data strain "g" waveform whose logical values are identifiable. In the pulse signal data strain "g" waveform, reference symbol VH depicts a logical value of "1" of binary logical values "0/1," and reference symbol VL depicts a logical value of"0."

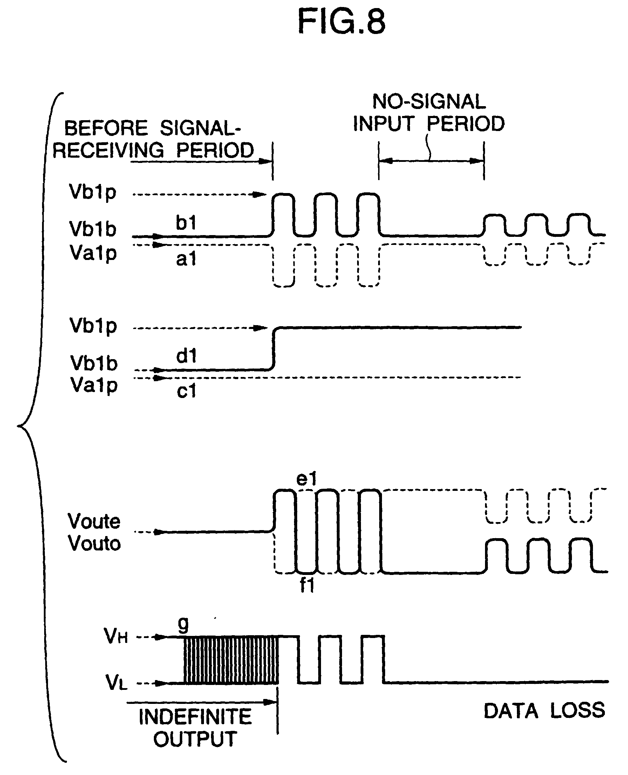

FIG. 8 is an illustration showing waveforms of signals appearing in the individual sections of the optical receiving circuit shown in FIG. 6 when a low-level burst signal is input to the optical receiving circuit a short time after a high-level burst signal has been input to the optical receiving circuit. The illustration depicts occurrence of a problem of loss of data, which would otherwise be caused when the peak value of the high-level burst signal held by the peak detection circuit A12 hinders the peak detection circuit A12 from reproducing a low-level burst signal immediately following the high-level burst signal.

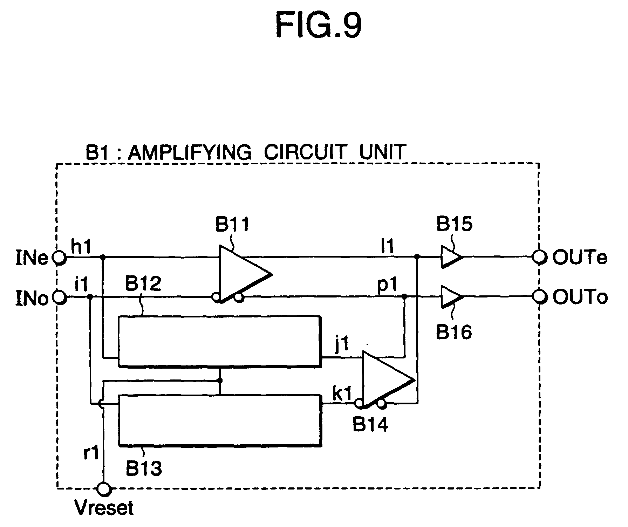

FIG. 9 is a circuit diagram showing an amplifying circuit unit B1 according to a third embodiment of the present invention for solving the previously-described problem. The amplifying circuit unit B1 corresponds to the amplifying circuit unit A1 when a common reset signal input terminal Vreset is interposed between the peak detection circuits A12 and A13. In the drawings, the individual sections of the amplifying circuit unit B1 are prefixed with B (such as peak detection circuits B12 and B13). The signal applied to the reset signal input terminal Vreset can render the potential of a signal input to the peak detection circuit B12 substantially identical with that of a signal output therefrom, as well as render the potential of a signal input to the peak detection circuit B13 substantially identical with that of a signal output therefrom.

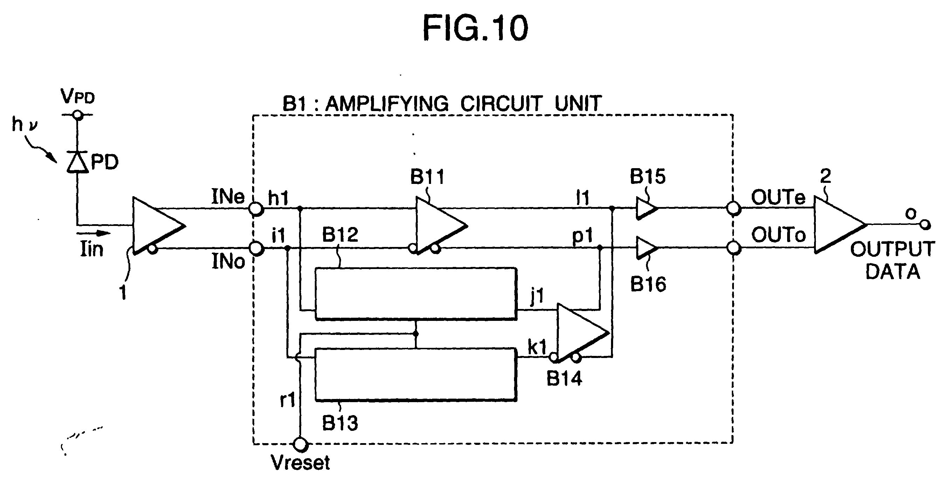

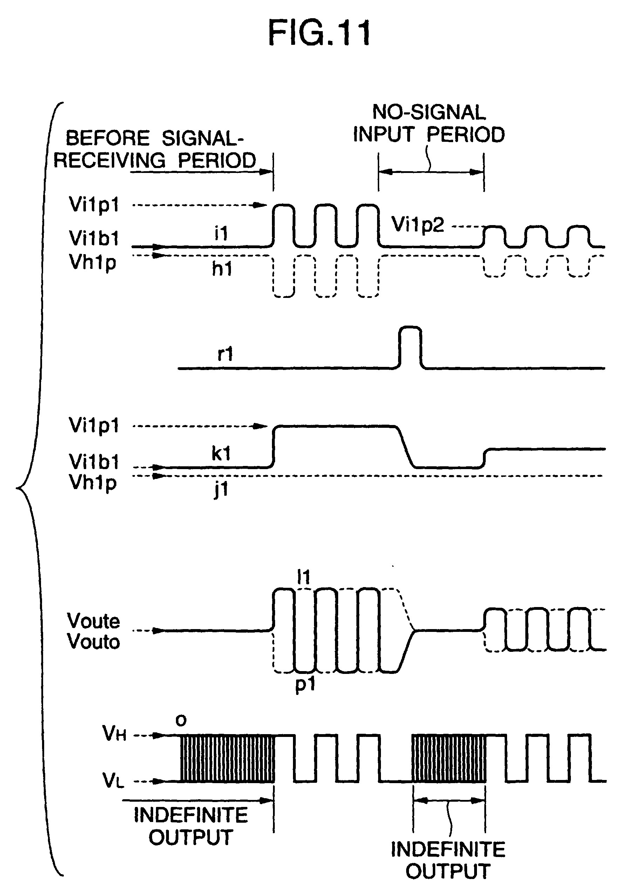

FIG. 10 is a circuit diagram showing an example configuration of an optical receiving circuit employing the amplifying circuit unit B1 according to the third embodiment shown in FIG. 9. FIG. 11 is an illustration showing waveforms of signals appearing in the individual sections of the amplifying circuit B1 and the waveform "o" of a signal output from the comparator 2 when a low-level burst signal is input to the optical receiving circuit shown in FIG. 10 a short time interval after a high-level burst signal has been input to the optical receiving circuit.

A differential amplifying circuit B11 receives difference input signals h1 and i1 and outputs differential output signals l1 and p1. The peak detection circuit B12 detects and holds the peak value of the differential input signal h1, and the peak detection circuit B13 detects and holds the peak value of the difference input signal i1. The peak detection circuit B12 outputs the thus-detected peak value to an offset compensation circuit B14 as a waveform signal j1, and the peak detection circuit B13 outputs the thus-detected peak signal to the offset compensation circuit B14 as a waveform signal k1. The peak detection circuit B13 detects and holes a peak value Vi1p1 of the high-level previous burst signal. During a period between burst signals during which no signal is input to the B1 amplifying circuit unit, a reset signal r1 is input to the reset signal input terminal Vreset, to thereby render the voltage of a signal input to the peak detection circuit B13 equal to that of a signal output therefrom. Consequently, the peak detection circuit B13 can accurately detect and hold the peak value Vi1p2 of a low-level burst signal following the high-level burst signal.

FIG. 11 shows no change arising between the peak value of the difference input signal h1 of the preceding burst signal and the peak value of the difference input signal H1 of the subsequent burst signal. It is also thought that a variation arises in a source voltage or bias light emitted from a optical transmission section. For these reasons, the voltage of a signal input to the peak detection circuit B12 must be made equal to that of the signal output therefrom, as in the case of the peak detection circuit B13. On the basis of a difference between the output waveforms j1 and k1, the offset compensation circuit B14 compensates for a d.c. potential offset of the differential output signal l1 stemming from a d.c. potential offset of the difference input signal h1 and a d.c. potential offset of the differential output signal p1 stemming from a d.c. potential offset of the difference input signal i1, thereby rendering the d.c. potential of the differential output signal l1 substantially identical with that of the differential output signal p1. After the differential output signals l1 and p1 have been buffered, the comparator 2 compares the voltages of the differential output signals l1 and p1, thereby producing a pulse signal data sequence waveform "o" whose logical value can be identifiable.

During the period of a respective burst, the differential output signals l1 and p1 have an identical d.c. level. Therefore, the amplifying circuit unit B1 can reproduce a low-level burst signal which is input with a short period of time after receipt of a high-level burst signal. Needless to say, the amplifying circuit unit B1 yields the same advantage as that yielded by the amplifying circuit A1.

### (Fourth Embodiment)

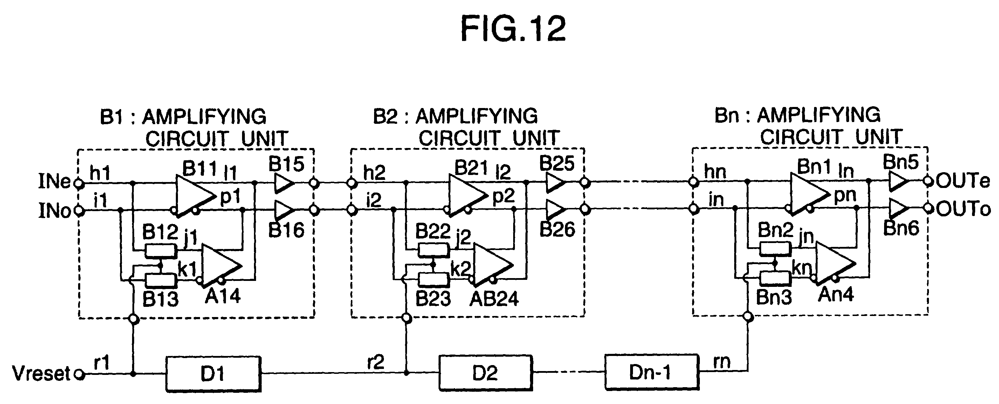

FIG. 12 is a circuit diagram of an amplifying circuit according to a fourth embodiment of the present invention. The amplifying circuit shown in FIG. 12 is identical in configuration with the amplifying circuit unit B1 according to the third embodiment shown in FIG. 9, and the amplifying circuit is formed by concatenation of "n" stages of amplifying circuit units B1 to Bn.

Delay circuits D1 to Dn-1 are interposed between respective reset signal terminals of amplifying circuit units B1 to Bn. The reset signal terminal of the amplifying circuit unit B1 of the first stage is taken as a reset signal input terminal Vreset of the entire amplifying circuit. If the amplifying circuit units of all the stages are changed simultaneously, the amplifying circuit of the second stage and those of subsequent stages are affected by the response characteristic of the amplifying circuit of a previous stage and may not be reset correctly.

By employment of the delay circuits D1 to Dn-1, the amplifying circuits are sequentially reset from that of the first stage, wherewith the amplifying circuits of all the stages can be correctly reset to the initial state. The daisy-chained amplifying circuits according to the fourth embodiment shown in FIG. 12 yield the same advantage as that yielded by the amplifying circuit unit A1 according to the second embodiment shown in FIG. 5 and that yielded by the amplifying circuit unit B1 according to the third embodiment shown in FIG. 9.

### (Fifth Embodiment)

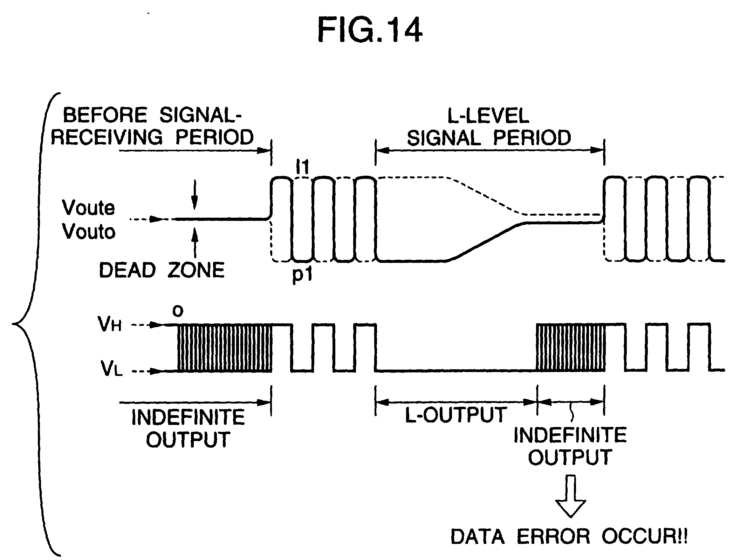

It is ascertained that the signal "g" output from the optical receiving circuit shown in FIG. 6 becomes indefinite during a period in which the optical receiving circuit receives no signal. It is also ascertained that the signal "o" which is shown in FIG. 11 and is output from the optical receiving circuit shown in FIG. 10 becomes indefinite during a period in which the optical receiving circuit receives no signal as well as during a period in which the optical receiving circuit receives no signal after having been reset. It is thought that an indefinite output from an amplifying circuit unit may adversely affect the operation of a subsequent amplifying circuit unit. As shown in FIG. 14, even during the period of receipt of data, in a case where signals of the same sign (i.e., low-level signals shown in the illustrated example) are continuously received by the optical amplifying circuit unit, the capacitor holding the peak value discharges electric charge, thereby resulting in appearance of a period during which an output of the amplifying circuit unit becomes indefinite, which would also cause an error in data. Such a phenomenon arises even in daisy-chained amplifying circuits such as those shown in FIGS. 5 and 12.

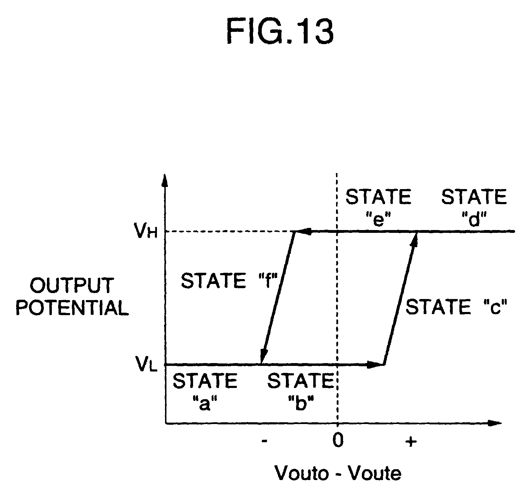

The amplifying circuit of the fifth embodiment has a configuration for preventing occurrence of such a phenomenon. The amplifying circuit according to the fifth embodiment corresponds to the amplifying circuit A1 according to the first embodiment shown in FIG. 1, the daisy-chained optical amplifying circuit units according to the second embodiment shown in FIG. 5, the amplifying circuit unit B1 according to the third embodiment shown in FIG. 9, or the daisy-chained amplifying circuit units according to the fourth embodiment shown in FIG. 12, so long as a comparator having input/output characteristics, such as that shown in FIG. 13 (for example, the comparator 2 provided after the output terminals OUTe and OUTo) is connected to the output terminal of the amplifying circuit, the output terminal of the amplifying circuit unit, or the output terminal of the daisy-chained amplifying circuit units.

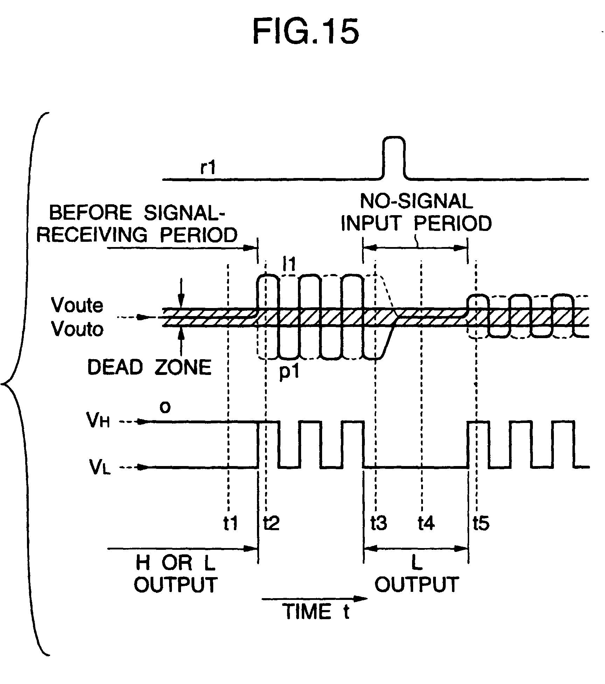

FIG. 15 is an illustration showing waveforms of the differential output signals l1 and p1 and the waveform "o" of the signal output from the comparator 2, in a case where the comparator 2 of the amplifying circuit unit B1 of the optical receiving circuit shown in FIG. 10 is given a hysteresis characteristic shown in FIG. 13. In FIG. 15, time t1 corresponds to state "a" or state "d" shown in FIG. 13; time t2 corresponds to state "d"; time t3 corresponds to state "a"; time t4 corresponds to state "b"; and time t5 corresponds to state "d." The waveform "o" of the output signal is fixed to either a high level or a low level during a period in which the optical receiving circuit receives no signal. As a result, the optical receiving circuit yields an advantage of the waveform "o" of the output signal being fixed to a low level even after resetting of the amplifying circuit.

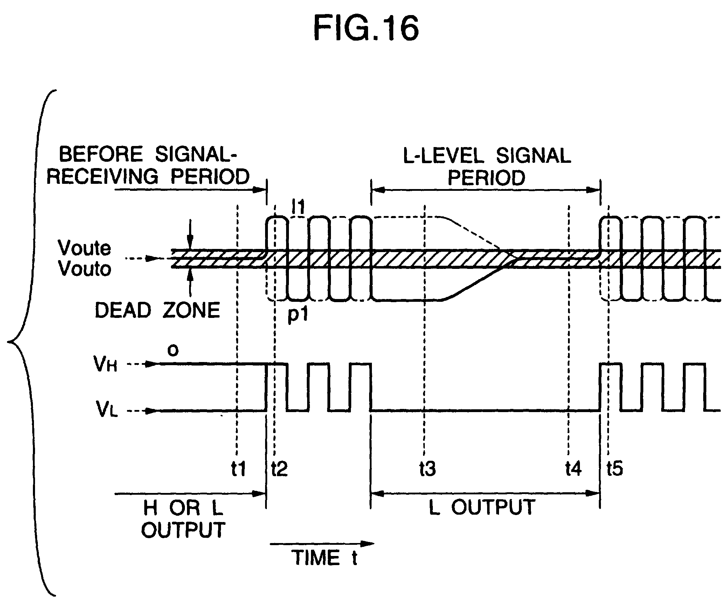

FIG. 16 is an illustration showing the waveforms of the low-level differential output signals l1 and p1 and the waveform "o" of the signal output from the comparator 2, in a case where the comparator 2 of the amplifying circuit unit A1 of the optical receiving circuit shown in FIG. 6 or the comparator 2 of the amplifying circuit unit B1 of the optical receiving circuit shown in FIG. 10 is given the hysteresis characteristic shown in FIG. 13. In FIG. 16, time t1 corresponds to state "a" or state "d" shown in FIG. 13; time t2 corresponds to state "d"; time t3 corresponds to state "a"; time t4 corresponds to state "b"; and time t5 corresponds to state "d." The waveform "o" of the output signal is fixed to a low level during a period in which the optical receiving circuit continuously receives low-level signals, thus preventing occurrence of an error in data.

As has been described, the amplifying circuit unit according to the present invention enables compensation of a d.c. potential offset of a differential output signal stemming from a d.c. potential offset of a difference input signal, thereby achieving high-speed response to initiation of data entry.

The amplifying circuit is constructed by concatenation of a plurality of amplifying circuit units arranged in stages. An offset voltage of an output signal due to variations in integrated circuits of an amplifying circuit unit of one stage, which would be caused during manufacture of the integrated circuits, is compensated for by an amplifying circuit unit of the next stage. The amplifying circuit of the present invention can yield an advantage of the ability to materialize a wide input dynamic range by means of improving minimum receiving sensitivity.

The amplifying circuit unit according to the present invention has the configuration of the amplifying circuit unit mentioned previously and enables resetting of peak detection circuits such that the potential of a positive-phase input signal is made substantially equal to that of a positive-phase output signal and such that the potential of a negative-phase input signal is made substantially equal to that of a negative-phase output signal. Accordingly, in addition to the advantage yielded by the previously-described amplifying circuit, the amplifying circuit unit yields high-speed response to initiation of data entry even in a case where a low-level burst signal is input to the amplifying circuit immediately after a high-level burst signal.

The amplifying circuit unit according to the present invention is formed by concatenation of the amplifying circuit units arranged in stages, and delay circuits are provided between reset signal terminals of respective amplifying circuit units. A reset signal terminal of an amplifying circuit unit of the first stage is taken as a reset signal of all the amplifying circuit units. In addition to the high-speed response of the amplifying circuit unit, the amplifying circuit unit yields an advantage of ability to ensure an input dynamic range.

A comparator having a hysteresis characteristic is connected to an output terminal of the amplifying circuit unit according to the present invention and yields an advantage of preventing an output of the amplifying circuit unit from becoming indefinite in the event of occurrence of a period during which signals of the same sign are continuously input to the amplifying circuit unit or the amplifying circuit unit receives no signal, in addition to the advantage yielded by the previous amplifying circuit unit. In addition to the previously-described advantage yielded by the amplifying circuit, the amplifying circuit yields an advantage of being able to prevent an output of the amplifying circuit from becoming indefinite, which would otherwise occur during a period in which signals of the same sign are continuously input to the amplifying circuit or the amplifying circuit receives no signal.

## Claims

1. An amplifying circuit unit comprising:
a differential amplifying circuit which receives and amplifies positive-phase and negative-phase signals;
peak detection circuits, one for detecting a peak value of the positive-phase signal input to the differential amplifying circuit and the other for detecting a peak value of the negative-phase signal input to the differential amplifying circuit; and
an offset compensation circuit for compensating for a d.c. potential offset arising in a differential signal output from the differential amplifying circuit, on the basis of the peak values detected by the peak detection circuits.

2. An amplifying circuit unit comprising:
a differential amplifying circuit, including
first and second transistors having identical characteristics;
a first common constant-current power source connected to the emitter or source of the first transistor and the emitter or source of the second transistor;
a first load connected to the collector or drain of the first transistor directly or by way of cascade-connected transistors;
a second load connected to the collector or drain of the first transistor directly or by way of cascade-connected transistors, wherein the differential amplifying circuit receives a positive-phase signal by way of the base or gate of the first transistor and a negative-phase signal by way of the base or gate of the second transistor and outputs an amplified positive-phase signal by way of the collector or drain of the first transistor and an amplified negative-phase signal by way of the collector or drain of the second transistor;
a first peak detection circuit for detecting a peak value of the positive-phase signal input to the differential amplifying circuit;
a second peak detection circuit for detecting a peak value of the negative-phase signal input to the differential amplifying circuit; and
an offset compensation circuit including,
third and fourth transistors having identical characteristics;
a second common constant-current power source connected to the emitter or source of the third transistor and the emitter or source of the fourth transistor;
the base or gate of the third transistor being connected to an output terminal of the first peak detection circuit;
the base or gate of the fourth transistor being connected to an output terminal of the second peak detection circuit;
the collector or drain of the third transistor being connected to the collector or drain of the second transistor of the differential amplifying circuit; and
the collector or drain of the fourth transistor being connected to the collector or drain of the first transistor of the differential amplifying circuit.

3. The amplifying circuit as defined in claim 1 or 2, wherein
the amplifying circuit units arranged into stages are cascaded.

4. An amplifying circuit unit comprising:
a differential amplifying circuit which receives and amplifies positive-phase and negative-phase signals;
peak detection circuits, one for detecting a peak value of the positive-phase signal input to the differential amplifying circuit and the other for detecting a peak value of the negative-phase signal input to the differential amplifying circuit;
an offset compensation circuit for compensating for a d.c. potential offset arising in a differential signal output from the differential amplifying circuit, on the basis of the peak values detected by the peak detection circuits; and
a reset signal terminal provided for the peak detection circuits, wherein the peak detection circuits have a reset terminal which, upon receipt of a reset signal, can make the potential of a positive-phase input signal substantially equal to that of a positive-phase output signal and the potential of a negative-phase input signal substantially equal to that of a negative-phase output signal.

5. An amplifying circuit unit comprising:
a differential amplifying circuit, including
first and second transistors having identical characteristics;
a first common constant-current power source connected to the emitter or source of the first transistor and the emitter or source of the second transistor;
a first load connected to the collector or drain of the first transistor directly or by way of cascade-connected transistors;
a second load connected to the collector or drain of the first transistor directly or by way of cascade-connected transistors, wherein the differential amplifying circuit receives a positive-phase signal by way of the base or gate of the first transistor and a negative-phase signal by way of the base or gate of the second transistor and outputs an amplified positive-phase signal by way of the collector or drain of the first transistor and an amplified negative-phase signal by way of the collector or drain of the second transistor;
a first peak detection circuit for detecting a peak value of the positive-phase signal input to the differential amplifying circuit;
a second peak detection circuit for detecting a peak value of the negative-phase signal input to the differential amplifying circuit; and
an offset compensation circuit including,
third and fourth transistors having identical characteristics;
a second common constant-current power source connected to the emitter or source of the third transistor and the emitter or source of the fourth transistor;
the base or gate of the third transistor being connected to an output terminal of the first peak detection circuit;
the base or gate of the fourth transistor being connected to an output terminal of the second peak detection circuit;
the collector or drain of the third transistor being connected to the collector or drain of the second transistor of the differential amplifying circuit; and
the collector or drain of the fourth transistor being connected to the collector or drain of the first transistor of the differential amplifying circuit, wherein the first and second peak detection circuits have a reset terminal which, upon receipt of a reset signal, can make the potential of a signal input to the first peak detection circuit substantially equal to that of a signal output therefrom and the potential of a signal input to the second peak detection circuit substantially equal to that of a signal output therefrom.

6. An amplifying circuit comprising:
a plurality of circuit units cascaded into a plurality of stages; and
delay circuits interposed between the amplifying circuit units, wherein a reset signal terminal of an amplifying circuit unit of the first stage is taken as a reset signal terminal for all the amplifying circuit units.

7. The amplifying circuit unit as defined in any one of claims 1, 2, 4, and 5, wherein a comparator having a hysteresis characteristic is connected to an output terminal of the amplifying circuit unit.

8. The amplifying circuit as defined in claim 3 or 6, wherein a comparator having a hysteresis characteristic is connected to an output terminal of the amplifying circuit.
